# EUROPEAN PATENT SPECIFICATION

(11) **EP 1 766 697 B1**
(45) Date of publication and mention of the grant of the patent: **24.02.2010**
(21) Application number: 05763653.2
(22) Date of filing: 30.03.2005
(51) Int. Cl.: H01L 33/00

(54) **LIGHT EMITTING DEVICES HAVING CURRENT BLOCKING STRUCTURES AND METHODS OF FABRICATING LIGHT EMITTING DEVICES HAVING CURRENT BLOCKING STRUCTURES**
LICHTEMITTIERENDE BAUELEMENTE MIT STROMBLOCKIERUNGSSTRUKTUREN UND VERFAHREN ZUR HERSTELLUNG VON LICHTEMITTIERENDEN BAUELEMENTEN MIT STROMBLOCKIERUNGSSTRUKTUREN
DISPOSITIFS ELECTROLUMINESCENTS DOTES DE STRUCTURES DE BLOCAGE DE COURANT ET PROCEDES DE FABRICATION DE CES DISPOSITIFS

(30) Priority: 30.06.2004 US 881814
(43) Date of publication of application: 28.03.2007
(73) Proprietor: CREE, INC., Durham, NC 27703 (US)
(72) Inventor: HABERERN, Kevin, Cary, NC 27511 (US); BERGMANN, Michael, John, Chapel Hill, NC 27516 (US); MIECZKOWSKI, Van, Apex, North Carolina 27516 (US); EMERSON, David, Todd, Durham, NC 27707 (US)
(74) Representative: Bankes, Stephen Charles Digby
(86) International application number: PCT/US2005/010868
(87) International publication number: WO 2006/011936

(56) References cited:
- EP-A- 0 911 887
- EP-A- 0 929 109
- WO-A-03/058772
- WO-A-03/061021
- DE-A1- 19 817 368
- US-A- 5 245 622
- US-A1- 2004 066 820
- US-B1- 6 258 614
- LEE Y H ET AL: "CHARACTERISTICS OF TOP-SURFACE-EMITTING GAAS QUANTUM-WELL LASERS" IEEE PHOTONICS TECHNOLOGY LETTERS, IEEE SERVICE CENTER, PISCATAWAY, NJ, US, vol. 2, no. 9, 1 September 1990 (1990-09-01), pages 686-688, XP000170554 ISSN: 1041-1135
- HOI-JUN YOO ET AL: "FABRICATION OF VERTICAL-CAVITY FRONT-SURFACE-EMITTING LASER DIODE (FSELD) USING A HETEROJUNCTION BIPOLAR TRANSISTOR PROCESS" JAPANESE JOURNAL OF APPLIED PHYSICS, JAPAN SOCIETY OF APPLIED PHYSICS, TOKYO, JP, vol. 30, no. 3B, 15 March 1991 (1991-03-15), pages L492-L494, XP000224873 ISSN: 0021-4922
- PATENT ABSTRACTS OF JAPAN vol. 2003, no. 12, 5 December 2003 (2003-12-05) -& JP 2004 172189 A (SAKAI SHIRO; NITRIDE SEMICONDUCTOR CO LTD), 17 June 2004 (2004-06-17)
- PATENT ABSTRACTS OF JAPAN vol. 2003, no. 05, 12 May 2003 (2003-05-12) -& JP 2003 017748 A (SEIWA ELECTRIC MFG CO LTD), 17 January 2003 (2003-01-17)
- PATENT ABSTRACTS OF JAPAN vol. 2000, no. 20, 10 July 2001 (2001-07-10) -& JP 2001 077414 A (SHOWA DENKO KK), 23 March 2001 (2001-03-23)
- PATENT ABSTRACTS OF JAPAN vol. 1999, no. 12, 29 October 1999 (1999-10-29) -& JP 11 186607 A (SHOWA DENKO KK), 9 July 1999 (1999-07-09)

## Description

This invention relates to semiconductor light emitting diodes and fabricating methods therefor.

Semiconductor light emitting devices, such as Light Emitting Diodes (LEDs) or laser diodes, are widely used for many applications. As is well known to those having skill in the art, a semiconductor light emitting device includes a semiconductor light emitting element having one or more semiconductor layers that are configured to emit coherent and/or incoherent light upon energization thereof. As is well known to those having skill in the art, a light emitting diode or laser diode, generally includes a diode region on a microelectronic substrate. The microelectronic substrate may be, for example, gallium arsenide, gallium phosphide, alloys thereof, silicon carbide and/or sapphire. Continued developments in LEDs have resulted in highly efficient and mechanically robust light sources that can cover the visible spectrum and beyond. These attributes, coupled with the potentially long service life of solid state devices, may enable a variety of new display applications, and may place LEDs in a position to compete with the well entrenched incandescent and fluorescent lamps.

Much development interest and commercial activity recently has focused on LEDs that are fabricated in or on silicon carbide, because these LEDs can emit radiation in the blue/green portions of the visible spectrum. See, for example, U.S. Patent 5,416,342 to Edmond et al., entitled *Blue Light-Emirting Diode With High External Quantum Efficiency,* assigned to the assignee of the present application. There also has been much interest in LEDs that include gallium nitride-based diode regions on silicon carbide substrates, because these devices also may emit light with high efficiency. See, for example, U.S. Patent 6,177,688 to Linthicum et al.. entitled *Pendeoepitaxial Gallium Nitride Semiconductor Layers On Silicon Carbide Substrates.*

The efficiency of conventional LEDs may be limited by their inability to emit all of the light that is generated by their active region. When an LED is energized, light emitting from its active region (in all directions) may be prevented from exiting the LED by, for example, a light absorbing wire bond pad. Typically in gallium nitride based LEDs, a current spreading contact layer is provided to improve the uniformity of carrier injection across the cross section of the light emitting device. Current is injected into the p-side of the LED through the bond pad and the p-type contact. Light generated in an active region of the device is proportional to the carrier injection. Thus, substantially uniform photon emission across the active region may result from the use of a current spreading layer, such as a substantially transparent p-type contact layer. However, a wire bond pad is typically not a transparent structure and, therefore, photons emitted from the active region of the LED that are incident upon the wire bond pad may be absorbed by the wire bond pad. For example, in some instances approximately 70% of the light incident on the wire bond pad may be absorbed. Such photon absorption may reduce the amount of light that escapes from the LED and may decrease the efficiency of the LED.

Lee et al, in an article entitled Characteristics of Top-Surface-Emitting GaAs Quantum-Well Lasers (IEEE Photonics Technology Letters, 2 No.9 September 1990) discloses self-aligned, top-surface-emitting, vertical-cavity, GaAs four-quantum-well lasers in which deep buried damaged layers formed by proton implantation are used to control vertical conductivity profiles for efficient current injection at the active region. The light output is through an output window formed in an Au/Zn electrode formed on the surface of the active region. Vertical damaged areas concentrate the current in the active region below the output window.

WO 03/061021 discloses nitride-based semiconductor structures with a ring p-doped contact, in which ion implantation is used to confine the current by selectively disordering the region adjacent the contacts, thus avoiding the emission of light beneath the contacts.

US-A-2004/0066820 discloses a single mode vertical cavity surface emitting laser (VCSEL) wherein a multi-quantum well active region is located between upper and lower mirrors, insulating layers being formed over the upper mirror, light from the active region being caused to pass through an aperture in the insulating layers, an equipotential layer above the insulating layers and dielectric layers on the surface of the laser. Upper electrical contacts are positioned on the surface of the equipotential layer, with isolation regions below them. VCSELs having similar current confinement structures formed by ion implantation are disclosed in WO 03/058772 A2.

Yoo et al (Japanese Journal of Applied Physics, 30, No. 3B, March 1991 pp. L492-L494) disclose front surface emitting laser diodes having both n and p electrodes on the top surface, laser light being emitted through a central aperture in the p electrode. The current flows bypassing high series resistance Distributed Bragg Reflector (DBR) stacks.

US-A-5245622 discloses vertical-cavity surface-emitting lasers wherein light from the active region passes through a stratified electrode comprising high and low doped layers and through a dielectric upper mirror on the surface of the stratified electrode. Electrical contacts are also positioned on the surface of the stratified electrodes, and blocking regions adjacent the active region are positioned below these contacts to confine the current, and hence the light emission, to a region below the upper mirror.

According to the present invention, there is provided a light emitting as defined in claim 1.

In additional embodiments of the present invention the active region includes a Group III-nitride based active region. The insulating region may also be a region that is not light absorbing. The insulating regions may include an implanted region.

Also in accordance with the present invention there is provided a method of fabricating a light emitting diode as defined in claim 7.

Preferred embodiments of the invention will now be described with reference to the accompanying drawings wherein:
**Figure 1** is a cross-sectional view illustrating semiconductor light emitting devices having a current blocking structure according to some embodiments of the present invention, and
**Figures 2A** and **2B** are cross-sectional views illustrating fabrication of semiconductor devices according to some embodiments of the present invention.

In the drawings, the thickness of layers and regions are exaggerated for clarity. Like numbers refer to like elements throughout. As used herein the term "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers refer to like elements throughout the specification.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in the Figures is turned over, elements described as being on the "lower" side of other elements would then be oriented on "upper" sides of the other elements. The exemplary term "lower", can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Embodiments of the present invention are described herein with reference to cross-section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, an etched region illustrated or described as a rectangle will, typically, have rounded or curved features. Thus, the regions illustrated in the figures are schematic in nature and their shapes are not intended to illustrate the precise shape of a region of a device and are not intended to limit the scope of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will also be appreciated by those of skill in the art that references to a structure or feature that is disposed "adjacent" another feature may have portions that overlap or underlie the adjacent feature.

Although various embodiments of LEDs disclosed herein include a substrate, it will be understood by those skilled in the art that the crystalline epitaxial growth substrate on which the epitaxial layers comprising an LED are grown may be removed, and the freestanding epitaxial layers may be mounted on a substitute carrier substrate or submount which may have better thermal, electrical, structural and/or optical characteristics than the original substrate. The invention described herein is not limited to structures having crystallize epitaxial growth substrates and may be utilized in connection with structures in which the epitaxial layers have been removed from their original growth substrates and bonded to substitute carrier substrates.

Some embodiments of the present invention may provide for improved efficacy of a light emitting device by reducing and/or preventing current flow in an active region of the device in a region beneath a wire bond pad or other light absorbing structure. Thus, some embodiments of the present invention may provide light emitting devices and methods of fabricating light emitting devices having a current blocking mechanism below the wire bond pad. By reducing and/or preventing current from being injected directly beneath the wire bond pad, the current may be more likely to be converted to photon emission in areas of the device not under the wire bond pad. Thus, there may be a reduced probability of light being absorbed by the wire bond pad. In some embodiments of the present invention, an increase in efficiency of a light emitting device according to some embodiments of the present invention may be proportional to the size of the wire bond pad.

Embodiments of the present invention may be particularly well suited for use in nitride-based light emitting devices such as Group III-nitride based devices. As used herein, the term "Group III nitride" refers to those semiconducting compounds formed between nitrogen and the elements in Group III of the periodic table, usually aluminum (Al), gallium (Ga), and/or indium (In). The term also refers to ternary and quaternary compounds such as AlGaN and AlInGaN. As is well understood by those in this art, the Group III elements can combine with nitrogen to form binary (*e.g*., GaN), ternary (*e.g*., AlGaN, AlInN), and quaternary (*e.g*., AlInGaN) compounds. These compounds all have empirical formulas in which one mole of nitrogen is combined with a total of one mole of the Group III elements. Accordingly, formulas such as AlₓGa₁₋ₓN where 0 ≤ x ≤ 1 are often used to describe them. However, while embodiments of the present invention are described herein with reference to Group III-nitride based light emitting devices, such as gallium nitride based light emitting devices, certain embodiments of the present invention may be suitable for use in other semiconductor light emitting devices, such as for example, GaAs and/or GaP based devices.

Light emitting diodes according to some embodiments of the present invention include a light emitting diode which includes one or more semiconductor layers, which may include silicon, silicon carbide, gallium nitride and/or other semiconductor materials, a substrate which may include sapphire, silicon, silicon carbide and/or other microelectronic substrates, and one or more contact layers which may include metal and/or other conductive layers. In some embodiments, ultraviolet, blue and/or green LEDs may be provided. The design and fabrication of semiconductor light emitting devices are well known to those having skill in the art and need not be described in detail herein.

For example, light emitting devices according to some embodiments of the present invention may include structures such as the gallium nitride-based LED and/or laser structures fabricated on a silicon carbide substrate such as those devices manufactured and sold by Cree, Inc. of Durham, North Carolina. The present invention may be suitable for use with LED and/or laser structures that provide active regions such as described in United States Patent Nos. 6,201,262; 6,187,606; 6,120,600; 5,912,477; 5,739,554; 5,631,190; 5,604,135; 5,523,589; 5,416,342; 5,393,993; 5,338,944; 5,210,051; 5,027,168; 4,966,862 and/or 4,918,497. Other suitable LED and/or laser structures are described in published U.S. Patent Publication No. US 2003/0006418 A1 entitled *Group III Nitride Based Light Emitting Diode Structures With a Quantum Well and Superlattice, Group III Nitride Based Quantum Well Structures and Group III Nitride Based Superlattice Structures,* published January 9, 2003, as well as published U.S. Patent Publication No. US 2002/0123164 A1 entitled *Light Emitting Diodes Including Modifications for Light Extraction and Manufacturing Methods Therefor.* Furthermore, phosphor coated LEDs, such as those described in U.S. Application Serial No. 10/659,241, entitled *Phosphor-Coated Light Emitting Diodes Including Tapered Sidewalls and Fabrication Methods Therefor,* filed September 9, 2003, may also be suitable for use in embodiments of the present invention. The LEDs and/or lasers may be configured to operate such that light emission occurs through the substrate. In such embodiments, the substrate may be patterned so as to enhance light output of the devices as is described, for example, in the above-cited U.S. Patent Publication No. US 2002/0123164 A1. These structures may be modified as described herein to provide blocking structures according to some embodiments of the present invention.

Thus, for example, embodiments of the present invention may be utilized with light emitting devices having bond pads of differing shapes or sizes. The light emitting devices may be on differing substrates, such as silicon carbide, sapphire, gallium nitride, silicon or other substrate suitable for providing Group III-nitride devices. The light emitting devices may be suitable for subsequent singulation and mounting on a suitable carrier. The light emitting devices may include, for example, single quantum well, multi-quantum well and/or bulk active region devices. Some embodiments of the present invention may be used with devices utilizing a tunneling contact on the p-side of the device.

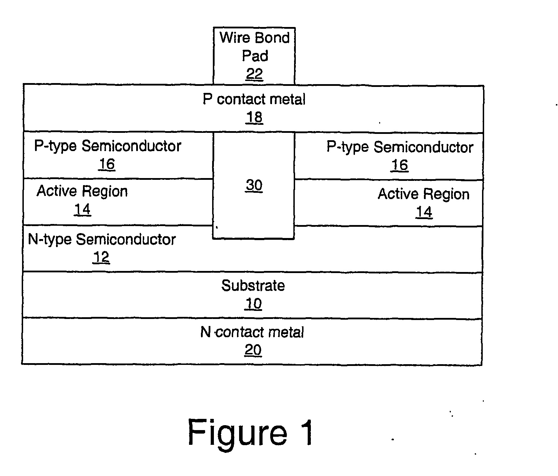

**Figure 1** is a cross-sectional schematic illustration of a light emitting device according to some embodiments of the present invention. As seen in **Figure 1****,** a substrate **10,** such as an n-type silicon carbide substrate, has an optional n-type semiconductor layer **12,** such as a gallium nitride based layer, provided thereon. The n-type semiconductor layer **12** may include multiple layers, for example, buffer layers or the like. In some embodiments of the present invention, the n-type semiconductor layer **12** is provided as a silicon doped AlGaN layer, that may be of uniform or gradient composition, and a silicon doped GaN layer.

While described herein with reference to a silicon carbide substrate, in some embodiments of the present invention other substrate materials may be utilized. For example, a sapphire substrate, GaN or other substrate material may be utilized. In such a case, the contact **20** may be located, for example, in a recess that contacts the n-type semiconductor layer **12,** so as to provide a second contact for the device. Other configurations may also be utilized.

An active region **14,** such as a single or double heterostructure, quantum well, multi-quantum well or other such active region may be provided on the n-type semiconductor layer. As used herein, the term "active region" refers to a region of semiconductor material of a light emitting device, that may be one or more layers and/or portions thereof, where a substantial portion of the photons emitted by the device when in operation are generated by carrier recombination. In the present invention, the active region refers to a region where substantially all of the photons emitted by the device are generated by carrier recombination.

Also illustrated in **Figure 1** is a p-type semiconductor layer **16.** The p-ype semiconductor material layer **16** may, for example, be a gallium nitride based layer, such as a GaN layer. In particular embodiments of the present invention, the p-type semiconductor layer **16** includes magnesium doped GaN. The p-type semiconductor layer **16** may include one or multiple layers and may be of uniform or gradient composition.

A first contact metal layer **18** of contact metal that provides an ohmic contact to the p-type semiconductor material layer **16** is also provided. In some embodiments, the first contact metal layer **18** may function as a current spreading layer. In particular embodiments of the present invention where the p-type semiconductor material layer **16** is GaN, the first contact metal layer **18** may be Pt. The first contact metal layer **18** is light permeable and in some embodiments is substantially transparent. In some embodiments, the first contact metal layer **18** may be a relatively thin layer of Pt. For example, the first contact metal layer **18** may be a layer of Pt that is about 54 Å thick. A light-absorbing wire bond pad **22** is provided on the first contact metal layer **18.**

A second contact metal layer **20** of contact metal that provides an ohmic contact to the n-type semiconductor material is also provided. The second contact metal layer **20** may be provided on a side of the substrate **10** opposite the active region **14.** As discussed above, in some embodiments of the present invention the second contact metal layer may be provided on a portion of the n-type semiconductor material layer **12,** for example, in a recess or at a base of a mesa including the active region. Furthermore, in some embodiments of the present invention, an optional back-side implant or additional epitaxial layers may be provide between the substrate **10** and the second contact metal layer **20.**

As is further illustrated in **Figure 1****,** a reduced conduction region **30** is provided in the active region **14** and is positioned beneath the wire bond pad **22.** In some embodiments of the present invention, the reduced conduction region **30** extends through the active region **14.** As used herein, "reduced conduction region" refers to a region with reduced current flow over other portions of the active region. In particular embodiments, the reduction is at least an order of magnitude and in some embodiments, substantially all current flow is blocked in the reduced conduction region. In some embodiments of the present invention the reduced conduction region **30** extends through the active region **14.** In the present invention, the reduced conduction region extends from the first contact layer **18** into the active region **14.** In some embodiments, the reduced conduction region extends from the first contact layer **18** through the active region **14.** The reduced conduction region **30** has substantially the same shape and/area as the area of the wire bond pad **22** on the first contact metal layer **18.** In other examples not forming part of the present invention, the reduced conduction region **30** has a slightly larger area than the wire bond pad **22** while in said other examples not forming part of the present invention, the reduced conduction region **30** has a slightly smaller area than the wire bond pad **22.** In certain embodiments of the present invention, the reduced conduction region **30** does not absorb light or only absorbs a relatively small amount of light. In the present invention, the reduced conduction region **30** is an insulating region.

The reduced conduction region **30** may reduce and/or prevent current flow through the active region **14** in the area beneath the wire bond pad **22** and, therefore, may reduce and/or prevent light generation through carrier recombination in this region. While not being bound by a particular theory of operation, this may be the case because the likelihood that a photon generated in the portion of the active region beneath the wire bond pad **22** is absorbed by the wire bond pad **22** may be higher than if the photon is generated in a portion of the active region that is not beneath the wire bond pad **22.** By reducing and/or eliminating the light generated in the active region beneath the wire bond pad **22,** the portion of the light generated by the light emitting device that is absorbed by the wire bond pad **22** may be reduced. For a given set of operating conditions, this reduction in the amount of light absorbed by the wire bond pad **22** may result in increased light extraction from the light emitting device as compared to a device operating under the same conditions where light is generated in the region beneath the wire bond pad **22.** Thus, some embodiments of the present invention provide a reduced conduction region **30** that extends into and, in some embodiments, through the active region **14** in the area beneath the wire bond pad **22.** This may reduce the likelihood that carriers may spread and be injected into the active region **14** beneath the wire bond pad **22** and, thereby, result in photon generation in the area beneath the wire bond pad **22.**

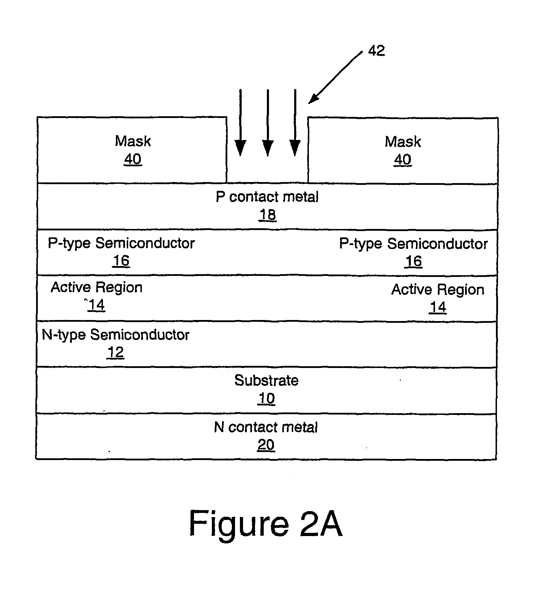

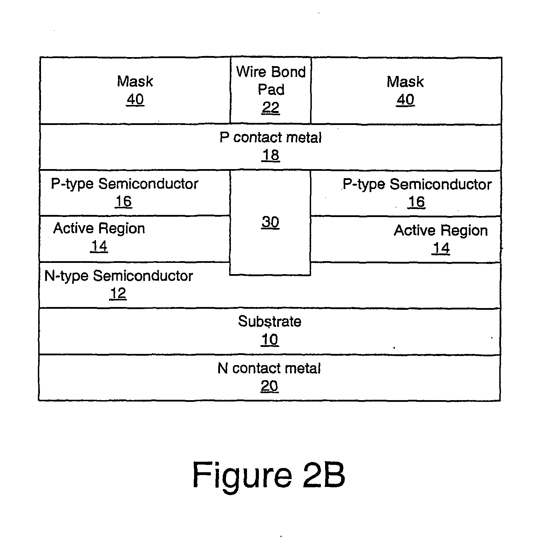

**Figures 2A** and **2B** illustrated operations according to some embodiments of the present invention for forming light emitting devices having an reduced conduction region as illustrated in **Figure 1****.** As seen in **Figure 2A****,** the various layers/regions of the light emitting device are fabricated. The particular operations in the fabrication of the light emitting device will depend on the structure to be fabricated and are described in the United States Patents and/or Applications cited above and/or are well known to those of skill in the art and, therefore, need not be repeated herein. **Figure 2A** also illustrates formation of a mask **40** having a window **42** corresponding to the region where the wire bond pad **22** is to be formed.

An implant is performed using the mask **40** so as to implant atoms into the active region **14** in the region of the wire bond pad **22** so as to form the reduced conduction region **30** as seen in **Figure 2B****.** Such an implant may, for example, be a nitrogen implant. For example, for a gallium nitride based device, implant conditions of 60keV, 2 x 10¹³ cm⁻³ N₂ may produce a non-absorbing and insulating region in Mg doped GaN. The particular implant energy and/or atoms may depend on the structure in which the reduced conduction region **30** is formed.

As seen in **Figure 2B****,** after implantation, the wire bond pad **22** may be formed in the window **42.** Thus, in the present invention, the wire bond pad **22** and the reduced conduction region **30** are self-aligned. The wire bond pad **22** may be formed, for example, by forming a layer or layers of the metal from which the wire bond pad **22** is formed and then planarizing the layers to provide the wire bond pad **22.** The mask **40** may subsequently be removed. Optionally, the mask **40** may be made of an insulating material, such as SiO₂ and/or AlN, and may remain on the device as, for example, a passivation layer, or be removed.

While embodiments of the present invention are illustrated in **Figures 1**, **2A** and **2B** with reference to particular light emitting device structures, other structures may be provided according to some embodiments of the present invention. Thus, embodiments of the present invention may be provided by any light emitting structure as defined in the independent claims. For example, current blocking mechanisms according to some embodiments of the present invention may be provided in conjunction with the exemplary light emitting device structures discussed in the United States Patents and/or Applications cited above.

Embodiments of the present invention have been described with reference to a wire bond pad **22.** As used herein, the term bond pad refers to a light absorbing contact structure. A bond pad may be a single or multiple layers, may be a metal and/or metal alloy and/or may be of uniform or non-uniform composition.

Furthermore, while embodiments of the present invention have been described with reference to a particular sequence of operations, variations from the described sequence may be provided while still benefiting from the teachings of the present invention. Thus, two or more steps may be combined into a single step or steps performed out of the sequence described herein. For example, the reduced conduction region **30** may be formed before or after forming the second contact metal layer **20**.

## Claims

1. A light emitting diode, comprising:
an active region (14) of semiconductor material in which the photons emitted by the device are generated, a first contact on the active region, including a light absorbing bond pad (22);
a p-type semiconductor material (16) disposed between the first contact and the active region (14);
an insulating region (30) disposed in the active region beneath the bond pad of the first contact and configured to reduce current flow through the active region in the region beneath the bond pad region of the first contact; and
a second contact (20) electrically coupled to the active region;
wherein the bond pad is formed on a bond pad region of the first contact, the bond pad and the insulating region being aligned with with each other and the insulating region having substantially the same shape, and approximately the same area, as the surface covered by the bond pad,
**characterised in that** the first contact comprises a light permeable metal layer (18) and **in that** the insulating region (30) extends from the light permeable metal layer (18) through the p-type semiconductor material into the active region (14).

2. A light emitting diode according to claim 1, wherein the insulating region (30) extends from the light permeable metal layer (18) through the active region (14).

3. A light emitting diode according to any preceding claim, wherein the active region (14) comprises a Group III-nitride based active region.

4. A light emitting diode according to any preceding claim, wherein the light permeable metal layer (18) is a layer of platinum.

5. A light emitting diode according to any preceding claim, wherein the insulating region (30) comprises a region that is not light absorbing.

6. A light emitting diode according to any preceding claim, wherein the insulating region (30) comprises an implanted region.

7. A method of fabricating a light emitting diode according to any preceding claim, comprising:
forming an active region (14) of semiconductor material;
forming a layer of p-type semiconductor material (16) on the active region;
forming a first contact comprising a light permeable metal layer (18) on the p-type semiconductor material and forming a light absorbing bond pad (22) on said light permeable metal layer;
forming an insulating region (30) in the active region beneath the bond pad, aligned with the bond pad and having substantially the same shape, and approximately the same area, as the surface covered by the bond pad, extending from the first contact (18) into the active region (14), and configured to block current flow through the active region in the region beneath the bond pad; and
forming a second contact (20) electrically coupled to the active region.

8. A method according to claim 7, wherein the insulating region (30) is formed to extend through the active region (14).

9. A method according to claim 7 or claim 8, wherein the active region comprises a Group III-nitride based active region.

10. A method according to any of claims 7 to 9, wherein the light permeable metal layer (18) is a layer of platinum.

11. A method according to any of claims 7 to 10, wherein the step forming an insulating region (30) comprises:
forming a mask layer (40) on the light permeable metal layer (18), the mask layer having an opening (42) corresponding to the bond pad region;
implanting atoms in the active region (14) through the opening in the mask layer; and
forming the bond pad (22) in the opening (42) in the mask layer (40).

## Patentansprüche

1. Lichtemittierende Diode, umfassend:
einen aktiven Bereich (14) aus Halbleitermaterial, worin die durch das Bauelement emittierten Photonen erzeugt werden;
einen ersten Kontakt am aktiven Bereich, unter Einschluss eines lichtabsorbierenden Kontaktierungsflecks (22);
ein p-Typ-Halbleitermaterial (16), das zwischen dem ersten Kontakt und dem aktiven Bereich (14) angeordnet ist;
einen isolierenden Bereich (30), der im aktiven Bereich unter dem Kontaktierungsfleck des ersten Kontakts angeordnet ist und so konfiguriert ist, dass der Stromfluss durch den aktiven Bereich im Bereich unterhalb des Kontaktierungsfleckbereiches des ersten Kontakts verringert wird; und
einen zweiten Kontakt (20), der elektrisch mit dem aktiven Bereich verbunden ist;
wobei der Kontaktierungsfleck auf einem Kontaktierungsfleckbereich des ersten Kontakts gebildet ist, wobei der Kontaktierungsfleck und der isolierende Bereich miteinander ausgerichtet sind und der isolierende Bereich im Wesentlichen die gleiche Gestalt und annähernd die gleiche Fläche wie die vom Kontaktierungsfleck bedeckte Oberfläche aufweist;
**dadurch gekennzeichnet, dass** der erste Kontakt eine lichtdurchlässige Metallschicht (18) umfasst und dass der isolierende Bereich (30) sich von der lichtdurchlässigen Metallschicht (18) durch das p-Typ-Halbleitermaterial in den aktiven Bereich (14) erstreckt.

2. Lichtemittierende Diode nach Anspruch 1, wobei sich der isolierende Bereich (30) von der lichtdurchlässigen Metallschicht (18) durch den aktiven Bereich (14) erstreckt.

3. Lichtemittierende Diode nach einem der vorstehenden Ansprüche, wobei der aktive Bereich (14) einen aktiven Bereich auf der Basis eines Gruppe III-Nitrids umfasst.

4. Lichtemittierende Diode nach einem der vorstehenden Ansprüche, wobei es sich bei der lichtdurchlässigen Metallschicht (18) um eine Platinschicht handelt.

5. Lichtemittierende Diode nach einem der vorstehenden Ansprüche, wobei der isolierende Bereich (30) einen Bereich umfasst, der nicht lichtabsorbierend ist.

6. Lichtemittierende Diode nach einem der vorstehenden Ansprüche, wobei der isolierende Bereich (30) einen implantierten Bereich umfasst.

7. Verfahren zur Herstellung einer lichtemittierenden Diode nach einem der vorstehenden Ansprüche, umfassend:
das Bilden eines aktiven Bereiches (14) aus Halbleitermaterial;
das Bilden einer Schicht aus p-Typ-Halbleitermaterial (16) auf dem aktiven Bereich;
das Bilden eines ersten Kontakts, der eine lichtdurchlässige Metallschicht (18) auf dem p-Typ-Halbleitermaterial umfasst, und das Bilden eines lichtabsorbierenden Kontaktierungsflecks (22) auf der lichtdurchlässigen Metallschicht;
das Bilden eines isolierenden Bereichs (30) im aktiven Bereich unter dem Kontaktierungsfleck, der mit dem Kontaktierungsfleck ausgerichtet ist und im Wesentlichen die gleiche Gestalt und annähernd die gleiche Fläche wie die vom Kontaktierungsfleck bedeckte Oberfläche aufweist und der sich vom ersten Kontakt (18) in den aktiven Bereich (14) erstreckt und so konfiguriert ist, dass er den Stromfluss durch den aktiven Bereich in den Bereich unterhalb des Kontaktierungsflecks blockiert; und
das Bilden eines zweiten Kontakts (20), der elektrisch mit dem aktiven Bereich verbunden ist.

8. Verfahren nach Anspruch 7, wobei der isolierende Bereich (30) so ausgebildet ist, das er sich durch den aktiven Bereich (14) erstreckt.

9. Verfahren nach Anspruch 7 oder 8, wobei der aktive Bereich einen aktiven Bereich auf der Basis eines Gruppe III-Nitrids umfasst.

10. Verfahren nach einem der Ansprüche 7 bis 9, wobei es sich bei der lichtdurchlässigen Metallschicht (18) um eine Platinschicht handelt.

11. Verfahren nach einem der Ansprüche 7 bis 10, wobei die Stufe der Bildung eines isolierenden Bereiches (30) folgendes umfasst:
das Bilden einer Maskenschicht (40) auf der lichtdurchlässigen Metallschicht (18), wobei die Maskenschicht eine Öffnung (42) aufweist, die dem Kontaktierungsfleckbereich entspricht;
das Implantieren von Atomen in den aktiven Bereich (14) durch die Öffnung in der Maskenschicht; und
das Bilden des Kontaktierungsflecks (22) in der Öffnung (42) in der Maskenschicht (40).

## Revendications

1. Diode électroluminescente, comprenant :
une région active (14) de matériau semi-conducteur dans laquelle les photons émis par le dispositif sont générés,
un premier contact sur la région active, comprenant un plot de connexion (22) absorbant la lumière ;
un matériau semi-conducteur de type p (16) disposé entre le premier contact et la région active (14) ;
une région d'isolement (30) disposée dans la région active au-dessous du plot de connexion du premier contact et configurée pour réduire la circulation de courant à travers la région active dans la région au-dessous de la région de plot de connexion du premier contact ; et
un deuxième contact (20) couplé électriquement à la région active ;
dans laquelle le plot de connexion est formé sur une région de plot de connexion du premier contact, le plot de connexion et la région d'isolement étant alignés l'un avec l'autre et la région d'isolement ayant sensiblement la même forme, et à peu près la même aire, que la surface recouverte par le plot de connexion,
**caractérisée en ce que** le premier contact comprend une couche métallique perméable à la lumière (18), et **en ce que** la région d'isolement (30) s'étend de la couche métallique perméable à la lumière (18) à travers le matériau semi-conducteur de type p dans la région active (14).

2. Diode électroluminescente selon la revendication 1, dans laquelle la région d'isolement (30) s'étend de la couche métallique perméable à la lumière (18) à travers la région active (14).

3. Diode électroluminescente selon l'une quelconque des revendications précédentes, dans laquelle la région active (14) comprend une région active à base de nitrure du groupe III.

4. Diode électroluminescente selon l'une quelconque des revendications précédentes, dans laquelle la couche métallique perméable à la lumière (18) est une couche de platine.

5. Diode électroluminescente selon l'une quelconque des revendications précédentes, dans laquelle la région d'isolement (30) comprend une région qui n'absorbe pas la lumière.

6. Diode électroluminescente selon l'une quelconque des revendications précédentes, dans laquelle la région d'isolement (30) comprend une région implantée.

7. Procédé de fabrication d'une diode électroluminescente selon l'une quelconque des revendications précédentes, consistant à :
former une région active (14) de matériau semi-conducteur ;
former une couche de matériau semi-conducteur de type p (16) sur la région active ;
former un premier contact comprenant une couche métallique perméable à la lumière (18) sur le matériau semi-conducteur de type p et former un plot de connexion (22) absorbant la lumière sur ladite couche métallique perméable à la lumière ;
former une région d'isolement (30) dans la région active au-dessous du plot de connexion, alignée avec le plot de connexion et ayant sensiblement la même forme, et à peu près la même aire, que la surface recouverte par le plot de connexion, s'étendant du premier contact (18) dans la région active (14), et configurée pour bloquer la circulation de courant à travers la région active dans la région au-dessous du plot de connexion ; et
former un deuxième contact (20) couplé électriquement à la région active.

8. Procédé selon la revendication 7, dans lequel la région d'isolement (30) est formée de manière à s'étendre à travers la région active (14).

9. Procédé selon la revendication 7 ou la revendication 8, dans lequel la région active comprend une région active à base de nitrure du groupe III.

10. Procédé selon l'une quelconque des revendications 7 à 9, dans lequel la couche métallique perméable à la lumière (18) est une couche de platine.

11. Procédé selon l'une quelconque des revendications 7 à 10, dans lequel l'étape de formation d'une région d'isolement (30) comprend :
la formation d'une couche de masque (40) sur la couche métallique perméable à la lumière (18), la couche de masque comportant une ouverture (42) correspondant à la région de plot de connexion ;
l'implantation d'atomes dans la région active (14) à travers l'ouverture dans la couche de masque ; et
la formation du plot de connexion (22) dans l'ouverture (42) dans la couche de masque (40).
